# EUROPEAN PATENT APPLICATION

(11) **EP 1 980 910 A1**
(43) Date of publication of application: **15.10.2008**
(21) Application number: 07706544.9
(22) Date of filing: 11.01.2007
(51) Int. Cl.: G03F 7/004, C03C 8/14, G03F 7/031

(54) **PHOTOSENSITIVE COMPOSITION, DISPLAY MEMBER, AND PROCESS FOR PRODUCING THE SAME**

(30) Priority: 12.01.2006 JP 2006004464
(71) Applicant: TORAY INDUSTRIES, INC., Tokyo 103-8666 (JP)
(72) Inventor: UEOKA, Takenori, Otsu-shi, Shiga, 520-0842 (JP); GOTO, Kazuki, Shiga, 520-0842 (JP); MATSUBA, Satoshi, Itami-shi, Hyogo, 664-0856 (JP)
(74) Representative: Hager, Thomas Johannes
(86) International application number: PCT/JP2007/050197
(87) International publication number: WO 2007/080904

(57) **Abstract**

Disclosed is a photosensitive composition comprising 50 to 5% by weight of a photosensitive organic component and 50 to 95% by weight of a glass powder, wherein the glass powder contains 70 to 85% by weight of Bi₂O₃, 3 to 15% by weight of SiO₂, 5 to 20% by weight of B₂O₃, 0 to 3% by weight of ZrO₂ and 1 to 10% by weight of ZnO, expressed in terms of oxide. The present invention provides a photosensitive composition which enables fine pattern work by photolithography to be used in various members of a flat panel display and a fluorescence emission tube.

## Description

### TECHNICAL FIELD

The present invention relates to a photosensitive composition used in various members of a flat panel display and a fluorescent emission device (cold cathode tube) member. The present invention also relates to a method for producing a display member using the same, and a display member.

### BACKGROUND ART

As an image display unit to be replaced by a Braun tube, an image display unit using an electron emission element as a self-luminous type discharge display is proposed. This image display unit has large contrast between lightness and darkness, low power dissipation and excellent moving picture performance as compared with a liquid crystal display and a plasma display and also can meet the requirements of high precision, and thus its need as a display with good balance has being increasing. Electron emission elements are roughly classified into two kinds of electron emission elements such as a hot cathode electron emission element and a cold cathode electron emission element. Examples of the cold cathode electron emission element include a field emission type element, a metal/insulating layer/metal type (MIM type) element and a surface electric conduction type (SED) element. The image display unit using the cold cathode electron emission element displays images by irradiating a fluorescent substance with an electron beam emitted from the electron emission element to generate fluorescence. There is also proposed an application as a fluorescent emission device which generates fluorescence by a similar principle and is not used as an image display unit but is used as light source, and development has been carried out. Of these electron emission type planar image display unit and fluorescent emission device, a CNT-field emission display (FED) using a carbon nano-tube (CNT) as the electron emission element has intensively been developed because it is easy to achieve electron emission characteristics and an increase in the area.

These electron emission type planar image display unit and fluorescent emission device are provided with a front glass substrate and a back glass substrate, each having its own function. The back glass substrate is provided with a plurality of electron emission elements and matrix-shaped wirings for connecting these elements. These wirings are disposed in X and Y directions and intersect with each other at a portion of the electrode of the electron emission element. A patterned insulating film is required to insulate both elements at the intersected portion.

With respect to formation of an insulating film, a vacuum deposition method, a printing method, a method of forming a silicon oxide film by a sputter method, and a method of coating a photosensitive composition on the entire surface using screening printing and forming a pattern by ultraviolet exposure have been developed (Japanese Unexamined Patent Publication (Kokai) No. 2002-245928 (columns 29-30)).

With respect to a photosensitive composition which forms a member such as an insulating layer for display, various photosensitive compositions such as a photosensitive composition comprising a photosensitive organic component containing a photosensitive monomer, a binder polymer and a photopolymerization initiator, and an inorganic component (Japanese Unexamined Patent Publication (Kokai) No. 11-185601 (claim 4)) and a photosensitive composition comprising a photosensitive component containing an alkali-soluble polyorganosiloxane resin composition and an acid generator, and an inorganic component are proposed. Of these photosensitive compositions, a photosensitive composition comprising a photosensitive organic component containing a photosensitive monomer and a photopolymerization initiator, and an inorganic component is preferably used because the photosensitive composition has a lot of variations in selection of materials and is easy to control the performances.

The photosensitive composition is coated on a substrate and a pattern is formed by photolithography, followed by firing so as to obtain a member for display and a member such as an insulating layer of the fluorescent emission device from the photosensitive composition. As glass which can be fired at low temperature, those containing a large amount of substances having the effect of decreasing the melting point, such as lead oxide; bismuth oxide and alkali metal oxide (Japanese Unexamined Patent Publication (Kokai) No. 10-182185 (claims 1, 8, 9) and Japanese Unexamined Patent Publication (Kokai) No. 11-323147 (claim 1, paragraph 30).

### DISCLOSURE OF THE INVENTION

It is required that a photosensitive composition can be fired at a low temperature so as to prevent deformation of a substrate by heat in the above firing step.

In particular, when an insulating layer of a field emission display and a fluorescence emission tube is produced, since the pattern has a small size such as several µm to several tens of µm, it is important that fine pattern work can be performed.

On the insulating layer or partition obtained by the above firing step, a gate electrode is formed using metal such as chromium. It is sometimes required that the step includes a step of etching the metal. In this etching step, etching resistance is also required of the photosensitive composition so as to endure a strong acidic etching liquid.

The present invention relates to a photosensitive composition which is used as various members of a flat panel display and a fluorescent emission device (cold cathode tube) member, and an object thereof is to provide a photosensitive composition which can be fired at comparatively low temperature and can be subjected to fine pattern work by photolithography, and also has resistance to an etching liquid used in a metal etching step.

The present invention relates to a photosensitive composition comprising 50 to 5% by weight of a photosensitive organic component and 50 to 95% by weight of a glass powder, wherein the glass powder contains 70 to 85% by weight of Bi₂O₃, 3 to 15% by weight of SiO₂ 5 to 20% by weight of B₂O₃, 0 to 3% by weight of ZrO₂ and 1 to 10% by weight of ZnO, expressed in terms of oxide.

Also, the present invention relates to a method for producing a display member, which comprises a step of coating the above photosensitive composition, an exposure step, a developing step, and a firing step in this order.

Also, the present invention relates to a display member comprising a substrate and an insulating layer made of glass formed on a substrate, wherein the glass has a composition comprising 70 to 85% by weight of Bi₂O₃, 3 to 15% by weight of SiO₂, 5 to 20% by weight of B₂O₃, 0 to 3% by weight of ZrO₂ and 1 to 10% by weight of ZnO, expressed in terms of oxide.

The photosensitive composition of the present invention has high storage stability and also can form a good fine pattern. The member obtained by using the photosensitive composition of the present invention is excellent in resistance to a strong acid. The photosensitive composition of the present invention can be fired at comparatively low temperature and therefore it can be preferably used as an insulating layer of a field emission display and an insulating layer of a fluorescent emission device.

### BEST MODE FOR CARRYING OUT THE INVENTION

The photosensitive composition of the present invention contains 50 to 5% by weight of a photosensitive organic component and 50 to 95% by weight of a glass powder. The content of the glass powder in the photosensitive composition is more preferably from 70 to 95% by weight, and still more preferably from 80 to 90% by weight. By adjusting the content of the glass powder to 50% by weight or more, the pattern shape upon firing can be improved. In contrast, by adjusting the content to 95% by weight or less, good photosensitive characteristics can be obtained. When the content of glass powder is more than 95% by weight, it becomes difficult to produce a photosensitive composition.

The average particle diameter of the glass powder used in the present invention is preferably from 0.1 to 5 µm, more preferably from 0.1 to 2 µm, and still more preferably from 0.1 to 1 µm. By using the glass powder having an average particle diameter of 0.1 µm or more, dispersion stability of the photosensitive composition is improved. By using the glass powder having an average particle diameter of 5 µm or less, workability of a thin film by photolithography is improved. The average particle diameter of the glass powder means the particle diameter in which a cumulative frequency of particle size distribution obtained by using a laser diffraction scattering method becomes 50%. When the particles have a nanosize or less and are aggregated, the value as measured by a BET method is preferably used. When the value as measured by a BET method is used, after the specific surface area is measured by a BET method, that is, a method of adsorption of an inert gas such as a nitrogen gas, the particle diameter is determined from the specific surface area assuming that particles are in the form of a sphere, and then the number average particle diameter is determined.

The average refractive index of the glass powder to be used is preferably 1.8 or more, more preferably 2.7 or less, and still more preferably 2.0 or more and 2.2 or less. When the average refractive index of the glass powder is more than the above range, the difference in the refractive index with the photosensitive organic component increases. It is difficult to satisfy the glass formulation of the present invention and to adjust the average refractive index of the glass powder to less than 1.8.

The refractive index of the glass powder is measured using an ellipsometer. It is accurate that the refractive index is measured by an exposure wavelength so as to confirm the effect. It is particularly preferred to measure using light having a wavelength of 350 to 650 nm. It is more preferred to measure the refractive index using i-rays (365 nm) or g-rays (436 nm).

Within the content of the glass powder, the specific gravity of the glass is preferably 4 or more and 7 or less, more preferably 4.5 or more and 6.5 or less, and still more preferably 5.5 or more and 6.3 or less. Within the above range, the degree of shrinkage upon firing can be decreased and the pattern shape after firing can be improved. The specific gravity of the glass powder is measured by an Archimedes's method.

Regarding the thermal expansion coefficient of the glass powder, the value of the thermal expansion coefficient α₅₀₋₃₅₀ at a temperature within a range from 50 to 350°C is preferably from 70 to 100 × 10⁻⁷/K, and more preferably from 72 to 90 × 10⁻⁷/K. The thermal expansion coefficient is preferably within the above range because it matches with the thermal expansion coefficient of a glass substrate and stress applied to the glass substrate upon firing can be decreased.

The glass powder of the photosensitive composition of the present invention is preferably a low-softening point glass so as to enable firing at comparatively low temperature. Examples of the low-softening point glass include those containing SiO₂, AL₂O₃, B₂O₃, ZnO, PbO, Bi₂O₃, ZrO₂, an alkali earth metal oxide and an alkali metal oxide as components, for example, borosilicate glass, alkali silicate glass, lead-based glass, and bismuth-based glass. Among these glasses, lead-based glass may cause environmental pollution, and therefore non-oxidized lead-based or slightly oxidized lead-based glass is preferred. A glass film obtained by firing the photosensitive composition of the present invention is preferably made of glass which is not easily dissolved even in the etching step, that is, glass having high etching resistance to an acid. Bismuth-based glass is particularly preferred because of high etching resistance to an acid. Bismuth-based glass is more preferred because it can be formed into fine particles and is suited for fine pattern work.

There arises the merit of being capable of utilizing a cheap glass substrate when the firing temperature is 500°C or lower, not to mention cost reduction and an improvement in productivity due to low temperature firing. A low softening point in the present invention means that the thermal softening point temperature of the glass is from 350 to 600°C, more preferably from 400 to 580°C, and still more preferably from 450 to 500°C.

The glass includes amorphous glass and crystalline glass, and both amorphous glass and crystalline glass can be employed in the present invention. Generally, amorphous glass has a property that it is crystallized when heated to a crystallization temperature. Since about several tens to 90% by volume of glass crystal is formed in the crystallized glass, the strength or thermal expansion coefficient can be improved. Shrinkage upon firing can be suppressed utilizing this fact. It is also possible to use glass which has already been crystallized. In the case of the crystalline glass, glass having a crystallization temperature of 550°C or lower is preferably employed.

The glass to be used is preferably non-alkali glass. When the glass contains an alkali metal or an alkali earth metal, for example, Na (sodium), Li (lithium), K (potassium), Ba (barium), or Ca (calcium), there may arise ion exchange with the glass component in the glass substrate or electrode upon or after firing and thus deterioration of electrical characteristics and mismatch of the thermal expansion coefficient thus causing defects, and is therefore not preferred.

As described above, low-softening point glass is used in the present invention. Zn-Bi-based and Bi-Zr-based glass are preferred but the low-softening point glass is not limited thereto.

It is preferred to use, as the component of the glass powder used in the present invention, Bi₂O₃ in a content within the range from 70 to 85% by weight, and more preferably from 73 to 85% by weight. When the content of Bi₂O₃ is less than 70% by weight, the resultant glass powder is inferior in etching resistance to an acid and is dissolved in the etching step. In contrast, when the content of Bi₂O₃ is more than 85% by weight, the heat resistant temperature of the glass decreases and it is not preferred in view of printing on the glass substrate.

The content of SiO₂ is preferably from 3 to 15% by weight. When the content is less than 3% by weight, it becomes difficult to produce glass. In contrast, when the content is more than 15% by weight, the thermal softening point increases and it becomes difficult to print on the glass substrate.

The content of B₂O₃ is preferably from 5 to 20% by weight, and mote preferably from 7 to 15% by weight. Electrical, mechanical and thermal characteristics such as electrical insulation properties, strength, thermal expansion coefficient, and compactness can be adjusted by mixing with B₂O₃. When the content is more than 20% by weight, stability of the glass to an acid or water deteriorates.

The content of ZrO₂ is preferably within a range from 0 to 3% by weight, more preferably from 0.01 to 2.5% by weight, and still more preferably from 0.01 to 1% by weight. While ZrO₂ improves acid resistance of the glass material, when the content is more than 3% by weight, the glass becomes non-uniform and a residue is produced by etching with an acid.

The content of ZnO is preferably from 1 to 10% by weight, and more preferably from 2 to 5% by weight. When the content is less than 1% by weight, the effect of improving compactness decreases. In contrast, when the content is more than 20% by weight, the printing temperature decreases and it becomes difficult to control and also insulation resistance deteriorates, and is therefore not preferred.

The glass may contain other components such as Al₂O₃ as long as the effect of the present invention is not adversely affected. It is preferred that the glass does not contain lead, an alkali metal and an alkali earth metal, as described above. The content of these other components is preferably 10% by weight or less based on the glass powder.

As the material of the glass powder, for example, SiO₂ such as potash feldspar, albite, kaolin, or silica sand; Al₂O₃ such as alumina, aluminum hydroxide, potash feldspar, albite, or kaolin; B₂O₃ such as boric acid or borax; and ZnO such as zinc oxide can be used. These materials, Bi₂O₃ and ZrO₂ are mixed according to a predetermined formulation, melted at 900 to 1,200°C, quickly cooled to form a glass flit, which is ground to obtain fine powders.

Examples of the means of grinding glass include a ball mill, a bead mill, an attractor, and a sand mill. Among these means, a ball mill and a bead mill are preferably used.

The photosensitive composition of the present invention may contain fillers in addition to the above glass powders. Specific examples of the filler include ceramic powders such as SiO₂, Al₂O₃, ZrO₂, mullite, spinel, magnesia, ZnO, and titanium oxide. These fillers may be used alone, or plural kinds of them may be used in combination. It is preferred that the filler is not melted upon sintering. The content of the filler is preferably less than 20% by volume based on the inorganic component in the photosensitive composition. When the content is more than the above range, cracking may occur upon sintering and poor sintering may occur. The average particle diameter of the filler is preferably from 0.01 to 0.5 µm, and more preferably from 0.01 to 0.05 µm. The addition of the filler having an average particle diameter of 0.01 µm or more enables an improvement in strength of the member after firing. The use of the filler having an average particle diameter of 0.5 µm or less enables satisfactory photosensitive characteristics. The average particle diameter of the filler is determined by the following procedure. That is, after a specific surface area is measured by a BET method using a nitrogen gas, the particle diameter is determined from specific surface area assuming that particles are in the form of a sphere, and then the number average particle diameter is determined.

In the present invention, the photosensitive organic component may be a negative photosensitive organic component which is cured by light, or a positive photosensitive organic component which is solubilized by light.

In the present invention, as the photosensitive organic component, one or more kinds of compounds selected from the group consisting of (a) an ethylenically unsaturated group-containing compound and a photopolymerization initiator, (b) one or more kinds of cation-polymerizable compounds selected from the group consisting of a glycidyl ether compound, an alicyclic epoxy compound and an oxetane compound, and a photocation polymerization initiator, and (c) one or more kinds of compounds selected from the group consisting of a quinonediazide compound, a diazonium compound and an azide compound are preferably used.

The ethylenically unsaturated group-containing compound in the component (a) is preferably a (meth)acrylic compound because of a lot of variations. Examples thereof include methyl acrylate, ethyl acrylate, n-propyl acrylate, isopropyl acrylate, n-butyl acrylate, sec-butyl acrylate, iso-butyl acrylate, tert-butyl acrylate, n-pentyl acrylate, allyl acrylate, benzyl acrylate, butoxyethyl acrylate, butoxytriethylene glycol acrylate, cyclohexyl acrylate, 2-ethylhexyl acrylate, 2-hydroxyethyl acrylate, ethylene glycol diacrylate, diethylene glycol diacrylate, triethylene glycol diacrylate, polyethylene glycol diacrylate, dipentaerythritol hexaacrylate, dipentaerythritol monohydroxypentaacrylate, ditrimethylolpropane tetraacrylate, glycerol diacrylate, methoxydated cyclohexyl diacrylate, neopentyl glycol diacrylate, propylene glycol diacrylate, polypropylene glycol diacrylate, triglycerol diacrylate, trimethylolpropane triacrylate, acrylamide, aminoethyl acrylate, phenyl acrylate, phenoxyethyl acrylate, benzyl acrylate, 1-naphthyl acrylate, 2-naphthyl acrylate, bisphenol A diacrylate, and diacrylate of a bisphenol A-ethylene oxide adduct; those in which a portion or all of the acrylates in the molecule of the compound are replaced by methacrylates; and styrene, p-methylstyrene, o-methylstyrene, α-methylstyrene, γ-methacryloxypropyltrimethoxysilane, 1-vinyl-2-pyrrolidone, acrylic acid, methacrylic acid, itaconic acid, crotonic acid, maleic acid, fumaric acid, vinylacetic acid, and various urethane acrylates. In the present invention, these compounds can be used alone, or two or more kinds of them can be used in combination.

The content of the ethylenically unsaturated group-containing compound is preferably from 50 to 99% by weight, and more preferably from 60 to 90% by weight, based on the photosensitive organic component. The content of 50% by weight or more enables precise pattern work, while the content of 99% by weight or less enables satisfactory maintaining of a pattern shape after firing.

Examples of the photopolymerization initiator of the component (a) include benzophenone, methyl o-benzoylbenzoate, 4,4-bis(dimethylamine)benzophenone, 4,4-bis(diethylamino)benzophenone, 4,4-dichlorobenzophenone, thioxanthone, 2-methylthioxanthone, 2,4-dimethylthioxanthone, benzoin, benzoin methyl ether, anthraquinone, 2-t-butylanthraquinone, 2-methyl-[4-(methylthio)phenyl]-2-morpholino-1-propanone, and 2-benzyl-2-dimethylamino-1-(4-monopholinophenyl)-butanone. It is particularly preferred to use a photopolymerization initiator which is also sensitive to visible light having a wavelength of 400 to 450 nm. In the present invention, these photopolymerization initiators can be used alone, or two or more kinds of them can be used in combination. The content of the photopolymerization initiator is preferably within a range from 0.05 to 50% by weight, and more preferably from 1 to 35% by weight, based on the photosensitive organic component. Within the above range, sensitivity is excellent and also the remaining ratio of the exposed area can increase.

The component (b) contains one or more cation-polymerizable compounds selected from the group consisting of a glycidyl ether compound, an alicyclic epoxy compound and an oxetane compound, and a photocation polymerization initiator. Specific examples of the glycidyl ether compound of the component (b) include a bisphenol A type epoxy resin, a bisphenol F type epoxy resin, hydrogenated bisphenol A diglycidyl ether, bisphenolhexafluoroacetone diglycidyl ether, tetrabromobisphenol A diglycidyl ether, 1,3-bis(1-(2,3-epoxypropoxy)-1-trifluoromethyl-2,2,2-trifluoroethyl)benzene, 1,4-bis(1-(2,3-epoxypropoxy)-1-trifluoromethyl-2,2,2-trifluoroethyl)cyclohexyl, 4,4'-bis(2,3-epoxypropoxy)octafluorobiphenyl, a phenol novolak type epoxy resin, a cresol novolak type epoxy resin, and a trisphenolmethane type epoxy resin, and those obtained by modifying these epoxy resins with a carboxylic acid.

Specific examples of the alicyclic epoxy compound of the component (b) include 3,4-epoxycyclohexylmethyl-3,4-epoxycyclohexane carboxylate, 3,4-epoxycyclohexylethyl-8,4-epoxycyclohexane carboxylate, 2-(3,4-epoxycyclohexyl-5,5-spiro-3,4-epoxy)cyclohexane-m-dioxane, bis(3,4-epoxycyclohexyl)adipate, bis(3,4-epoxycyclohexylmethyl)adipate, bis(3,4-epoxycyclohexyl)ether, and bis(3,4-epoxycyclohexyl)diethylsiloxane.

Specific examples of the oxetane compound of the component (b) include oxetane compounds such as 2-ethyl-3-hydroxymethyloxetane, 1,4-bis[(3-ethyl-3-oxetanylmethoxy)methyl]benzene, and a silicone-modified oxetane compound.

The content of one or more kinds of cation-polymerizable compounds selected from the group consisting of a glycidyl ether compound, an alicyclic epoxy compound and an oxetane compound in the photosensitive organic component is preferably from 1 to 75% by weight, and more preferably from 5 to 35% by weight. Within the above range, the pattern shape can be satisfactorily maintained.

Specific examples of the photocation polymerization initiator of the component (b) include an aromatic sulfonium salt such as triphenylsulfonium hexafluorophosphate; an aromatic iodonium salt such as diphenyliodonium hexafluorophosphate; an aromatic iodosyl salt; an aromatic sulfoxonium salt; and a metallocene compound. When the photocation polymerization initiator is used, the amount is preferably within a range from 0.01 to 15% by weight based on the photosensitive organic component.

It is also preferred to add, as the photocation polymerization accelerator, 9,10-dimethoxy-2-ethylanthracene, 9,10-diethoxyanthracene, and 2,4-diethylthioxanthone.

As the component (c), one or more kinds of compounds selected from a diazonium compound and an azide compound are preferably used.

The quinonediazide compound of the component (c) means a compound obtained by diazotization of an aromatic compound having a hydroxyl group at the ortho- or para-position of an amino group, or a compound obtained by heating a compound having a hydroxyl group at the ortho- or para-position of a diazo group using a diazonium salt of a benzene or naphthalene derivative in an aqueous alkali solution. Generally, the diazo group is not ionized to form no salt, like a diazonium compound described hereinafter. Specific examples thereof include benzoquinonediazide sulfonic acid used commonly in positive PS plates, Wipon plates and photoresists, and a derivative thereof, naphthoquinonediazide sulfonic acid and a derivative thereof. Specifically, 1,2-naphthoquinone-2-diazide -4-sulfonic acid and a derivative thereof, 1,2-naphthoquinone-2-diazide-5-sulfonic acid and a derivative thereof are preferred.

These naphthoquinonediazide compounds are preferably used after mixing with an alkali-soluble component such as polyhydroxyphenyl, a pyrogallolacetone resin, a parahydroxystyrene copolymer or a phenolformaldehyde novolak resin or after converting into a derivative. Specific examples of preferred derivatives include polyhydroxyphenyls of 1,2-naphthoquinone-2-diazide sulfonic acid, and esters of a pyrogallolacetone resin, a parahydroxystyrene copolymer and a phenolformaldehyde novolak resin.

The content of the quinonediazide compound in the photosensitive organic component is preferably 1% by weight or more and 96% by weight or less, and more preferably 3% by weight or more and 80% by weight or less. When the content of the quinonediazide compound is less than 1% by weight, since the change in solvent solubility due to the quinonediazide compound upon exposure deceases, pattern forming properties deteriorate. In contrast, when the content is more than 96% by weight, there may arise a problem in dispersibility of the photosensitive composition.

The diazonium compound of the component (c) includes a condensed product of a diazomonomer and a condensing agent. Examples of the diazomonomer include 4-diazodiphenylamine, 1-diazo-4-N,N-dimethylaminobenzene, 1-diazo-4-N,N-diethylaminobenzene, 1-diazo-4-N-ethyl-N-hydroxyethylaminobenzene, 1-diazo-4-N-methyl-N-hydroxyethylaminobenzene, 1-diazo-2,5-diethoxy-4-benzoylaminobenzene, 1-diazo-4-N-benzylaminobenzene, 1-diazo-4-N,N-dimethylaminobenzene, and 1-diazo-4-morpholinobenzene. Examples of the condensing agent include formaldehyde, acetaldehyde, propionaldehyde, butylaldehyde, isobutylaldehyde, and benzaldehyde. Furthermore, a water-soluble diazo resin can be obtained by using chlorine ion or tetrachlorochlorine acid. Also, an organic solvent-soluble diazo resin can be obtained by using boron tetrachloride, hexafluorophosphoric acid, triisopropylnaphthalenesulfonic acid, 4,4'-biphenyldisulfonic acid, 2,5-dimethylbenzenesulfonic acid, 2-nitrobenzenesulfonic acid, and 2-methoxy-4-hydroxy-5-benzoylbenzenesulfonic acid.

Also, an equimolar reaction product of a diazonium compound and hydroxybenzophenones can be used. Both compounds are contacted with each other at a pH of 7.5 or less so as not to form an azo compound as a result of the reaction. The diazonium compound to be used may be the same as the diazo resin described above. As hydroxybenzophenones, 2,2',4,4'-tetrahydroxybenzophenone, 2,2'-dihydroxy-4,4'-dimethoxybenzophenone, an alkali salt of 2,2'-dihydroxy-4,4'-dimethoxy-5-sulfobenzophenone, and 2-hydroxy-4-methoxybenzophenone-5-sulfonic acid are used. Those having a sulfonic acid group are excellent in stability.

The content of the diazonium compound in the photosensitive organic component is preferably from 5 to 80% by weight, and more preferably from 10 to 50% by weight. When the content of the diazonium compound is too small, curing may be insufficient. In contrast, when the content is too large, there may arise a problem in storage stability of the composition.

The azide compound of the component (c) has an azide group in the molecule and specific examples thereof include 2,6-dichloro-4-nitroazidebenzene, azidediphenylamine, 3,3'-dimethoxy-4,4'-diazidediphenyl, 4'-methoxy-4-azidediphenylamine, 4,4'-diazidediphenylamine, and 4,4'-diazidediphenylmethane, 4. These azide compounds are used alone. In the case of an azide compound having a short photosensitive wavelength range, it is preferred to spectrally sensitize a photosensitive wavelength range toward a long wave side using a sensitizer such as 1-nitropyrene.

The content of the azide compound in the photosensitive organic component is preferably from 5 to 70% by weight, and more preferably from 10 to 50% by weight. When the content of the azide compound is too small, the photosensitive component may not be sufficiently cured. In contrast, when the content of the azide compound is too large, stability of the composition is adversely affected.

The photosensitive organic component is preferably an ethylenically unsaturated group-containing compound and a photoradical polymerization initiator as the component (a) in view of a lot of variations in selection of materials and ease of control of performances.

To those selected from the components (a) to (c), a basket-shaped silsesquioxane may be further added. The basket-shaped silsesquioxane may be added as it is in the photosensitive composition, or may be added after preliminarily reacting with the compound. When it is preliminarily reacted with other compounds, it is preferred to react with a compound constituting a photosensitive organic component in view of an improvement in compatibility.

The refractive index of the photosensitive organic component is usually within a range from 1.4 to 1.7. The average refractive index of the photosensitive organic component is decided by the following method. First, with respect to each component, a refractive index at a desired wavelength is measured by a V block method. Next, according to % by weight of the photosensitive organic component, the refractive index is determined by the addition of the respective refractive indexes. For example, when a certain photosensitive organic component is composed of A (50% by weight) and B (50% by weight) and the refractive index of a component A at a certain wavelength is 1.46, whereas, the refractive index of a component B at a certain wavelength is 1.58, the average refractive index of the photosensitive organic component is as follows: (1.46 × 0.5) + (1.58 × 0.5) = 0.73 + 0.79 = 1.52. Alternatively, after the photosensitive organic component is coated on a glass and dried, the refractive index is directly measured using an ellipsometer. It is accurate that the refractive index is measured by an exposure wavelength so as to confirm the effect. Since light having a wavelength range of 350 to 650 nm is used, the refractive index is preferably measured within the above range. It is more preferred to measure the refractive index using i-rays (365 nm) or g-rays (436 nm).

In the photosensitive composition containing a photosensitive organic component and a glass powder, the average refractive index of the photosensitive organic component is preferably closer to that of the glass powder. When both refractive indexes are close, light scattering at the interface between the photosensitive organic component and the glass powder is less likely to occur and it becomes possible to perform precise pattern work when a pattern is formed using photolithography.

While the bismuth-based glass used in the present invention has advantages such as low firing temperature and high etching resistance, it is difficult to adjust the average refractive index to less than 1.8 because of the large refractive index, as described above. Therefore, the difference in the refractive index between the photosensitive organic component and the glass powder is very large such as 0.1 to 1.3. When the difference in the refractive index is large, light does not sufficiently reach the inside of the photosensitive composition due to light scattering at the interface between the photosensitive organic component and the glass powder, and thus it becomes difficult to cure the portion far from the exposure surface.

However, when the photosensitive organic component contains a compound which absorbs alight to emit light rays having a longer wavelength than that of the wavelength absorbed (hereinafter referred to as a compound (A)), even if the difference in the refractive index between the photosensitive organic component and the glass powder is large, it becomes possible to cure the portion far from the exposure surface. The compound (A) absorbs light having a wavelength used for exposure to emit light rays having a longer wavelength than that of light absorbed, and the emitted light rays cure or solubilize the photosensitive organic component. The compound (A) absorbs ultraviolet rays thereby suppressing scattering, and also emits fluorescence having higher transmittance than that of ultraviolet rays from the compound (A) thereby also curing the portion far from the exposure surface.

The absorption wavelength range of the compound (A) is preferably from 320 to 410 nm, more preferably from 350 to 380 nm, and still more preferably from 360 to 375 nm. The maximum absorption wavelength of the compound (A) is more preferably within the above range.

The emission wavelength range of fluorescence of the compound (A) is preferably within a range from 400 to 500 nm, more preferably from 400 to 450 nm, and still preferably from 430 to 445 nm. The maximum emission wavelength of the compound (A) is preferably within the above range.

When these wavelengths are within the above ranges, scattering can be suppressed by effectively absorbing ultraviolet rays upon exposure, and also the photosensitive organic component can be cured or solubilized up to the deep portion, that is, the portion far from the exposure surface by emitting fluorescence in a wavelength range of a higher transmittance than that of ultraviolet rays to be irradiated.

Within the range of the content of the above compound (A), the molar extinction coefficient of the compound (A) is preferably 20,000 or more. Also, the molar extinction coefficient is preferably 60,000 or less. Within the above range, scattering of ultraviolet rays can be suppressed by effectively absorbing ultraviolet rays upon exposure, and also the photosensitive organic component can be cured or solubilized up to more of the deep portion.

The absorption wavelength of ultraviolet rays, and the emission wavelength and the molar extinction coefficient of fluorescence can be measured by a spectrofluorophotometer (F-2500, manufactured by Hitachi, Ltd.) and an ultraviolet-visible spectrophotometer (MultiSpec 1500, manufactured by Shimadzu Corporation).

It is possible to preferably use, as the compound (A) in the present invention, a cumarin-based fluorescent whitening agent, an oxazole-based fluorescent whitening agent, a stilbene-based fluorescent whitening agent, an imidazole-based a fluorescent whitening agent, a triazole-based fluorescent whitening agent, and imidazolone-based, oxacyanine-based, methine-based, pyridine-based, anthrapyridazine-based and carbostyryl-based fluorescent whitening agents. Because of excellent compatibility with a compound selected from (a) to (c) contained in the photosensitive organic component, and a binder polymer, a cumarin-based fluorescent whitening agent or an oxazole-based fluorescent whitening agent is more preferably used. The cumarin-based fluorescent whitening agent is particularly preferred because of large solubility in a polar solvent. The solubility of the compound (A) in the polar solvent is preferably 2 g/100 g of solvent or more, and more preferably 50 g/100 g of solvent or more. In view of solubility, a cumarin-based derivative is particularly preferred. These compounds may be used alone or in combination.

The cumarin-based fluorescent whitening agent has a cumarin structure represented by the formula shown below in the molecule. Specific examples of the cumarin-based fluorescent whitening agent include 7-diethyldiamino-4-methylcumarin, 7-hydroxy-4-methylcumarin, 7-ethylamino-4-methylcumarin, 7-dimethylamino-4-methylcumarin, and 7-amino-4-methylcumarin.

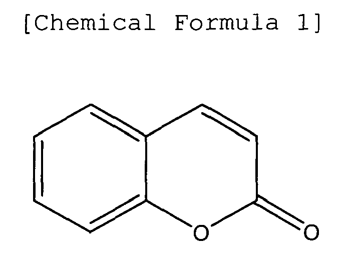

The oxazole-based fluorescent whitening agent has an oxazole ring represented by the following formula shown below in the molecule.

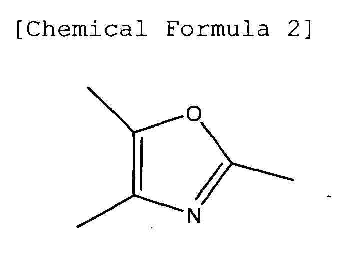

The stilbene-based fluorescent whitening agent has a stilbene structure represented by the following formula shown below in the molecule.

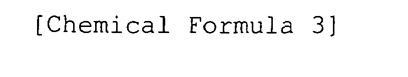

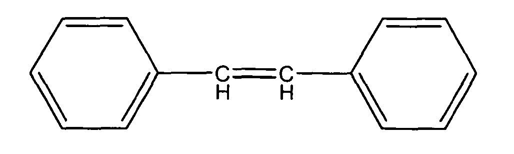

Specific examples of the stilbene-based fluorescent whitening agent include an s-triazine ring substituted compound of 4,4'-diaminostilbene-2,2'-disulfonic acid, a triazole of stilbene, an imidazole, and an oxazole-substituted compound.

The imidazole-based fluorescent whitening agent has an imidazole structure represented by the following formula shown below in the molecule.

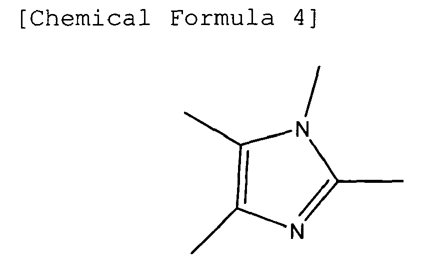

The triazole-based fluorescent whitening agent has a 5-mebered heterocyclic ring composed of three nitrogen atoms and two carbon atoms in the molecule. A specific example of the 5-membered heterocyclic ring includes the following ring

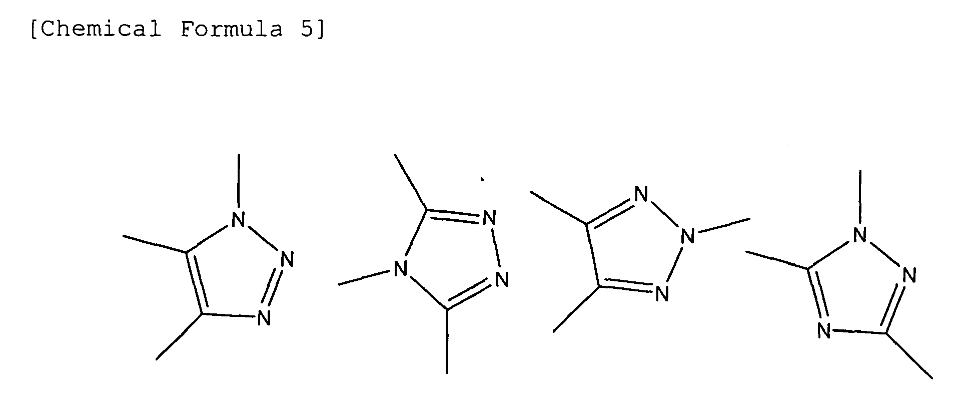

The content of the compound (A) in the present invention is preferably from 0.1 to 30% by weight based on the photosensitive organic component. In the applications such as a field emission member and a fluorescent emission device, the content is preferably from 2 to 20% by weight, and more preferably from 5 to 15% by weight. When the content is within the above range, it becomes possible to perform precise pattern work.

In the present invention, the photosensitive organic component preferably further contains a binder polymer, and can contain additives such as ultraviolet absorbers, sensitizers, polymerization inhibitors, plasticizers, dispersing agents, and antioxidants.

It is possible to use, as the binder polymer, various polymers such as an acrylic resin, an epoxy resin, a polyurethane resin, a polyester resin, a polyamide resin, a polyimide resin, a silicone resin, a melamine resin, a phenol resin, a cellulose derivative, and a polyvinyl alcohol. Among these polymers, polymethyl methacrylate, polyvinyl butyral, polyvinyl alcohol, ethyl cellulose, and a (meth)acrylate ester copolymer are preferred. In view of dispersibility and developing properties of an inorganic powder, and pattern forming properties by exposure, the binder polymer preferably has a reactive functional group such as a carboxyl group, a hydroxyl group, or an ethylenically unsaturated double bond.

A thermal decomposition temperature of the binder polymer is preferably 500°C or lower, more preferably 450°C or lower, and is preferably 150°C or higher, and more preferably 400°C or higher. When a binder polymer having a thermal decomposition temperature of 150°C or higher is used, thermostability of a photosensitive composition is maintained and thus it becomes possible to perform satisfactory pattern work without impairing photosensitivity in the respective steps of from the step of coating the composition to the step of performing pattern work. When a binder polymer having a thermal decomposition temperature of 500°C or lower is used, cracking, peeling, warping and deformation in the firing step can be prevented. It becomes possible to adjust the thermal decomposition temperature of the binder polymer by selecting a monomer of a copolymerizable component. The thermal decomposition temperature of the copolymer can be lowered by using a monomer, which can be thermally decomposed at low temperature, as the copolymerizable component. Examples of the component, which can be thermally decomposed at low temperature include methyl methacrylate, isobutyl methacrylate, and α-methylstyrene. The thermal decomposition temperature is determined by the following procedure. That is, about 20 mg of a sample is set to a TG measuring device (TGA-50, manufactured by Shimadzu Corporation) and the temperature is raised to 700°C at a temperature raising rate of 20 to 0.6°C/min under an air atmosphere at a flow rate of 20 ml/min. A chart with a plotted relation between the temperature (ordinate) and the change in weight (abscissas) is printed and a tangent line of the portion before decomposition (portion parallel to the abscissas) and the portion during decomposition is drawn and the temperature of the intersection point is taken as a thermal decomposition temperature.

The Tg (glass transition temperature) of the binder polymer is preferably from -60 to 100°C, more preferably from 40 to 95°C, and still more preferably from 60 to 90°C. The tack of the paste can be reduced by adjusting Tg to 30°C or higher. Adhesion of the paste to the glass substrate can be maintained by adjusting the Tg to 100°C or lower. When the Tg is more than 100°C, cracking may often occur in the pattern after exposure and development of the film of the photosensitive paste composition.

The glass transition temperature of the binder polymer can be controlled by the kind of the monomer to be copolymerized and the content of the monomer constituting the polymer. In this case, the glass transition temperature of the binder polymer can be calculated from the glass transition temperature of a homopolymer of each monomer constituting the binder polymer in accordance with Fox's formula.
Fox's formula: 100/Tg = ∑(Wn/Tgn)
Tg: Glass transition temperature of binder polymer (absolute temperature)
Wn: Weight fraction (%) of homopolymer of each monomer
Tgn: Glass transition temperature (absolute temperature) of homopolymer of each monomer

In the present invention, a copolymerizable monomer may be selected in accordance with Fox's formula so as to adjust the glass transition temperature of the binder polymer within a range from -60 to 100°C, and then polymerized to obtain a binder polymer.

The Tg of the resultant binder polymer was determined by the following procedure. That is, the temperature was raised at a temperature raising rate of 20°C/min under a nitrogen gas flow at a flow rate of 20 ml/min (sample weight: 10 mg) using a measuring device Model DSC-50 manufactured by Shimadzu Corporation and the temperature, at which a shift of a base line initiates, was taken as the Tg.

The glass transition temperature of the homopolymer of each monomer is described, for example, in engineering data of monomer manufacturers and Polymer Data Handbook (published by BAIFUKAN CO., LTD, edited by The Society of Polymer Science, Japan (basic edition), first edition on January 1986). Examples of the monomer (glass transition temperature) include methyl methacrylate (105°C), methacrylic acid (228°C), ethyl acrylate (-22°C), glycidyl methacrylate (74°C), methyl acrylate (10°C), and styrene (100°C).

The weight average molecular weight of the binder polymer to be used is preferably 100,000 or less, and more preferably from 5,000 to 80,000. By adjusting the weight average molecular weight to 100,000 or less, solubility in a developing solution is maintained, which enables precise patterning. Furthermore, since the viscosity of the binder polymer increases in proportion to the weight average molecular weight, the weight average molecular weight of the binder polymer is preferably decreased so as to maintain workability in the filtration, deaeration and coating steps by decreasing the viscosity of the photosensitive composition. The weight average molecular weight of the binder polymer was measured by size exclusion chromatography using tetrahydrofuran as a mobile phase. Using Shodex KF-803 as a column, the weight average molecular weight was calculated in terms of a polystyrene equivalent.

When the component (a) is used as the photosensitive organic component, a preferred binder polymer can be obtained by copolymerizing the above ethylenically unsaturated double bond-containing compound, or adding an ethylenically unsaturated group-containing compound having a reactive functional group at a portion of a reactive functional group of the binder polymer obtained by copolymerization. Specifically, a binder polymer having a carboxyl group and an ethylenically unsaturated double bond can be obtained by adding an epoxy group-containing acrylate compound such as glycidyl methacrylate to a portion of a carboxyl group of a binder polymer having an unsaturated carboxylic acid as a copolymerizable component. The acid value of such a binder polymer is preferably adjusted within a range from 50 to 140 (mgKOH/g). By adjusting the acid value to 140 or less, the allowance width of development can be widened. By adjusting the acid value to 50 or more, solubility of the unexposed area in an alkali developing solution is maintained and a high precise pattern can be obtained. The acid value is determined by titration with an aqueous 0.1 N potassium hydroxide solution after dissolving 1 g of a binder polymer in 100 mL of ethanol. Furthermore, double bond density of the binder polymer is preferably adjusted within a range from 0.1 to 2.5 mmol/g, and more preferably from 0.2 to 1.6 mmol/g. When the double bond density is less than 0.1 mmol/g, a pattern is not sufficiently formed under exposure, resulting in large thickness loss and drastic deterioration of developing properties. In contrast, when the double bond density is more than 2.5 mmol/g, cracking, peeling and warping occur during the firing step.

The content of the binder polymer in the photosensitive organic component is preferably from 1 to 50% by weight, and more preferably from 5 to 40% by weight, based on the photosensitive organic component. By adjusting within a range from 1 to 50% by weight, pattern processability is compatible with characteristics such as shrinkage upon firing.

It is also effective to add ultraviolet absorbers to the photosensitive composition of the present invention. The addition of the ultraviolet absorber enables suppression of scattering of light in the exposure step, thus obtaining a pattern which has a high aspect ratio and is highly precise, and also has high resolution. As the ultraviolet absorber, an organic dye, especially an organic dye having a high UV absorption coefficient at a wavelength range from 350 to 450 nm is preferably used. The organic dye is preferred by the following reason. That is, even when added as the ultraviolet absorber, the organic dye does not remain in a glass film after firing and can reduce deterioration of characteristics of an insulating film due to the ultraviolet absorber. Such a compound is preferably an azo-based or benzophenone-based dye because it is easy to control the absorption wavelength to a desired wavelength range. The amount of the organic dye in the photosensitive organic component is preferably from 0.05 to 5% by weight, and more preferably from 0.1 to 1% by weight. It is not preferred that the amount of the organic dye to be added is less than 0.05% by weight based on the photosensitive organic component because the addition effect of the ultraviolet absorber decreases. Also, it is not preferred that the amount of the organic dye to be added is more than 5% by weight because characteristics of the insulating film after firing deteriorate.

The sensitizer is added so as to improve the sensitivity. Specific examples of the sensitizer include 2,4-diethylthioxanthone, isopropylthioxanthone, 2,3-bis(4-diethylaminobenzal)cyclopentanone, 2,6-bis(4-dimethylaminobenzal)cyclohexanone, 2,6-bis(4-dimethylaminobenzal)-4-methylcyclohexanone, and Michler's ketone. In the present invention, these sensitizers can be used alone, or one or more kinds of them can be used in combination. Some sensitizers can also be used as a photopolymerization initiator. The amount of the sensitizer to be added is preferably from 0.05 to 30% by weight, and more preferably from 0.1 to 20% by weight, based on the photosensitive component. When the amount of the sensitizer is too small, the effect of improving photosensitivity is not exerted. In contrast, when the amount of the sensitizer is too large, the remaining ratio of the exposed area may become too small.

Furthermore, polymerization inhibitors are preferably added. Specific examples of the polymerization inhibitor include hydroquinone, a monoesterified compounds of hydroquinone, N-nitrosiphenylamine, phenothiazine, p-t-butyl catechol, N-phenylnaphthylamine, 2,6-di-t-butyl-p-methylphenol, Chloranil, and pyrogallol. When the polymerization inhibitor is added, the amount is preferably from 0.001 to 1% by weight based on the entire composition.

Plasticizer or antioxidants may be used. Specific examples of the plasticizer include dibutyl phthalate, dioctyl phthalate, polyethylene glycol, and glycerin. Specific examples of the antioxidant include 2,6-di-t-butyl-p-cresol, butylated hydroxyanisole, 2,6-di-t-4-ethylphenol, and 2,2-methylene-bis(4-methyl-6-t-butylphenol). When the plasticizer is added, the amount is preferably from 0.5 to 10% by weight based on the entire composition. When the antioxidant is added, the amount is preferably from 0.001 to 1% by weight based on the entire composition.

The photosensitive composition of the present invention can be prepared in the following manner. A binder polymer, a compound selected optionally from the components (a) to (c), a compound (A) and various additives as photosensitive organic components are mixed, followed by filtration to prepare an organic vehicle. To the organic vehicle, a glass powder treated optionally is added, followed by homogeneous mixing using a kneader such as a ball mill to prepare a photosensitive composition.

The viscosity of the photosensitive composition is appropriately adjusted according to the amount of inorganic components, thickeners, organic solvents, plasticizers and suspending agents to be added, and is preferably within a range from 2 to 200 Pa•s (Pascal•seconds). For example, when coating to a glass substrate is carried out by a spin coating method, the viscosity is preferably from 2 to 5 Pa·s. In order to obtain a film having a thickness of 10 to 20 µm by coating once using a screen printing method, the viscosity is preferably from 50 to 200 Pa•s. When a blade coater method or a die coater method is used, the viscosity is preferably from 2 to 20 Pa•s.

Examples of the organic solvent used to adjust the viscosity of the solution include methyl cellosolve, ethyl cellosolve, butyl cellosolve, methyl ethyl ketone, dioxane, acetone, cyclohexanone, cyclopentanone, isobutyl alcohol, isopropyl alcohol, 3-methoxy-3-methyl-1-butanol, tetrahydrofuran, dimethyl sulfoxide, γ-butyrolactone, bromobenzene, chlorobenzene, dibromobenzene, dichlorobenzene, bromobenzoic acid, chlorobenzoic acid, and an organic solvent mixture contaning one or more kinds of them. Since the photosensitive composition of the present invention is used in a state where the solvent is volatilized, the organic solvent is not included in the photosensitive organic component when the component ratio is calculated.

The photosensitive composition of the present invention is preferably used as various members of flat panel displays and fluorescence emission tube (cold cathode tube) members, and is particularly preferably used as field emission members typified by an insulating layer of field emission displays.

Field emission means a physical phenomenon in which when a semiconductor or an electric conductor such as metal is used as a cathode in vacuum and an anode is disposed in the vicinity of the surface of the cathode, electrons are emitted from the surface of the cathode to the anode in vacuum. In the present invention, the field emission member means a member utilizing such field emission. Specific examples thereof include, but are not limited to, a field emission display, a backlight of a liquid crystal display, a field emission lamp, an electron beam source of a scanning electron microscope, and a miniature vacuum tube.

When the field emission member is produced using the photosensitive composition of the present invention, a glass substrate is preferably used as the substrate. As the glass substrate, for example, soda lime glass, heat resisting glass (PD200 manufactured by Asahi Glass Co. Ltd., PP8 manufactured by Nippon Electric Glass Co. Ltd., CS25 manufactured by SAINT-GOBAIN KK, CP600V manufactured by Central Glass Co. Ltd., etc.) can be preferably used. It is also possible to use a ceramic substrate, a metal substrate, a semiconductor substrate (AlN, CuW, CuMo, SiC substrate, etc.), and various plastic films. On these substrates, one or more layers of an insulator, a semiconductor or a conductor, or a combination thereof may be formed.

The method for producing a field emission member will be described by way of a method for producing an insulating layer of a field emission display as an example.

On a glass substrate on which an ITO electrode is formed, as the substrate, a photosensitive composition is entirely or partially coated. As a coating method, a general method using screen printing, bar coating, roll coating or slit die coating can be used. The coating thickness can be adjusted by selecting the number of coating opertations, mesh of the screen, and viscosity of the photosensitive composition. Taking account of shrinkage caused by drying or firing, the thickness of the film formed after drying is from 5 to 100 µm, preferably from 5 to 60 µm, and more preferably from 5 to 40 µm.

When the photosensitive composition is coated plural times, the photosensitive composition coated first time and the photosensitive composition coated second time or later may be the same or different. When the photosensitive composition is coated plural times, after the first coating of the photosensitive composition, drying is preferably carried out before the second or later coating of the photosensitive composition. As a result, a decrease in thickness of a coating film upon second coating of the photosensitive composition can be prevented. The drying temperature and time vary depending on the formulation of the photosensitive composition and drying is preferably carried out at 50°C to 100°C for about 5 to 30 minutes. Drying is preferably carried out using a convection type drying furnace or an IR drying furnace.

The tack value of the film of the photosensitive composition obtained by drying is preferably from 0 to 4. When the tack value is within the above range, tack of the film of the photosensitive composition is suppressed and contact exposure can be easily used. When the tack value is not within the above range, since pinholes are formed on the film of the photosensitive composition or the photosensitive composition adheres to a photomask, it may become difficult to carry out contact exposure. When contact exposure can be carried out, it becomes possible to form a high precise pattern as compared with the case of an alignment method in which a gap is provided between the film of the photosensitive composition and the photomask. When the tack value is within the above range, since labor of washing the photomask can be saved, cost can be reduced. Evaluation of the tack value in the present invention is as described below.

The tack value varies depending on the glass transition temperature of the binder polymer; the molecular weight of the binder polymer, the amount of the organic solvent, and the proportion of inorganic particles in the photosensitive composition, and is greatly influenced by the glass transition temperature of the binder polymer.

The tack value can be adjusted within a range from 0 to 4 by using a photosensitive composition in which the glass transition temperature of the binder polymer contained in the photosensitive organic component is from 30 to 100°C.

The amount of the organic solvent remained in the photosensitive composition before exposure is 3% by weight or less, and preferably 1% by weight or less. When the amount is more than 3% by weight, the tack value becomes worse.

A pattern can be formed by exposure and development after forming the film of the photosensitive composition on the substrate as described above. The shape of the pattern required by the field emission member varies. In the case of the insulating layer of the field emission display, it is preferred to form a pattern including a circular hole having a diameter of 3 to 100 µm or a rectangular hole having a side of 3 to 100 µm. The side of the circular or rectangular hole is more preferably from 3 to 50 µm, and still more preferably from 3 to 20 µm. Within the above range, the effect of the photosensitive composition can be sufficiently exerted.

A method of mask exposure using a photomask and a method of direct drawing exposure with a laser beam can be used for exposure. In the case of exposure using a photomask, the exposure time can be shortened. In this case, a stepper or a proximity aligner can be used as an exposure apparatus.

Examples of the active light source to be used include visible rays, near ultraviolet rays, ultraviolet rays, near infrared rays, an electron beam, X-rays, and a laser beam. Among these active light sources, ultraviolet rays are preferred. As the light source, for example, a low-pressure mercury lamp, a high-pressure mercury lamp, an ultrahigh-pressure mercury lamp, a halogen lamp, and a germicidal lamp can be used. Among these light sources, an ultrahigh-pressure mercury lamp is preferred. The exposure conditions vary depending on the coating thickness, and exposure is carried out for 0.5 to 30 minutes using an ultrahigh-pressure mercury lamp having an output of 0.5 to 1,000 W/m². It is particularly preferred to perform exposure at a dose of about 0.05 to 1 J/cm². The wavelength of light used for exposure is preferably from 300 to 650, more preferably from 350 to 650 nm, still more preferably from 350 to 500 nm, and most preferably from 350 nm to 450 nm.

Subsequently, development is carried out using a developing solution. In this case, development is carried out using a dipping method, a spray method, a shower method, or a brush method. Among these methods, a shower method is preferred in view of realization of uniform development. When development is carried out by a shower method, the flow rate and pressure of the developing solution vary depending on the kind and concentration of the developing solution. The flow rate is preferably from 50 to 200 ml/min, and more preferably from 100 to 170 ml/min. The pressure is preferably from 0.05 to 0.2 MPa, and more preferably from 1 to 1.6 kg/min. As the developing solution, an organic solvent or aqueous solution, in which the organic component in the photosensitive composition can be dissolved or dispersed, is used. Also, an organic solvent-containing aqueous solution may be used. When a compound having a functional group such as a carboxyl group, a phenolic hydroxyl group or a silanol group exists in the photosensitive composition, development can be carried out using an aqueous alkali solution. As the aqueous alkali solution, an aqueous alkali metal solution such as aqueous sodium hydroxide, calcium hydroxide or a sodium carbonate aqueous solution can be used. However, an aqueous organic alkali solution is preferably used because an alkali component can be easily removed upon firing. As the organic alkali, a conventional amine compound can be used. Specific examples thereof include tetramethylammonium hydroxide, trimethylbenzylammonium hydroxide, monoethanolamine, and diethanolamine. The concentration of the alkali component of the aqueous alkali solution is preferably from 0.01 to 10% by weight, and more preferably from 0.1 to 5% by weight. When the concentration of an alkali is too low, the unexposed area is not removed. When the concentration of an alkali is too high, the pattern portion may be peeled to cause corrosion of the exposed area, and therefore it is not preferred. The temperature of the developing solution upon development is preferably from 20 to 50°C in view of process control.

It is preferred to add surfactants to the developing solution so as to improve wettability of the coating film with the photosensitive composition and uniformity of the development and to reduce the residue. As the surfactant, various surfactants such as nonionic, anionic, cationic and amphoteric surfactants can be used. Examples of the nonionic surfactant include polyethylene glycol type and polyhydric alcohol type surfactants, and specific examples thereof include polyethylene glycol, polyoxyethylene lauryl ether, polyoxyethylene nonyl ether, polyoxyethylene cetyl ether, polyoxyethylene stearyl ether, and polyoxyethylene oleyl ether.

Examples of the anionic surfactant include higher alcohol sulfate ester salts such as a sodium salt of lauryl alcohol sulfate; aliphatic alcohol phosphate ester salts such as a sodium salt of cetyl alcohol phosphate ester; alkylaryl sulfonates such as a sodium salt of dodecylbenzenesulfonic acid; and sulfonate salts of an alkylamide and sulfonate salts of a dibasic fatty acid ester, such as sodium sulfosuccinic acid dioctyl ester. A polyoxyethylene alkyl ether sulfate, a polyoxyethylene alkyl aryl ether sulfate, and alkylaryl sulfonates are preferred.

Examples of the cationic surfactant include amine type and quaternary ammonium salt type surfactants. Specific examples of the amine type surfactant include polyoxyethylenealkylamine, N-alkylpropyleneamine, and N-alkylpolyethylenepolyamine. Examples of the quaternary ammonium salt type surfactant include a long-chain primary amine salt, an alkyltrimethylammonium salt, a dialkyldimethylethylammonium salt, and an alkyldimethylammonium salt.

As the amphoteric surfactant, for example, a compound such as sodium N-methyl-N-pentadecylaminoacetate may be contained. The surfactant used preferably in the present invention is a nonionic or anionic surfactant.

The amount of the surfactant is preferably within a range from 0.01 to 20% by weight, more preferably from 0.05 to 10% by weight, and still more preferably from 0.1 to 5% by weight. When the amount is more than 20% by weight, developing properties may deteriorate. In contrast, when the amount is less than 0.01% by weight, it may become hard to exert the addition effect of the surfactant.

It is also preferred to carry out an ultrasonic wave treatment in a developing solution upon development. Furthermore, a frequency modulation type ultrasonic wave treatment, in which a frequency modulation type ultrasonic wave treatment is modulated at a wavelength range from 20 to 50 KHz, is preferred. By such an ultrasonic wave treatment, a fine and uniform pattern is formed and a large effect of reducing the residue is exerted.

By the above method, it is possible to form a pattern including circular holes having a thickness of 5 to 100 µm and a diameter of 3 to 100 µm or rectangular holes having a side of 3 to 100 µm on a substrate from the photosensitive composition of the present invention.

Subsequently, the substrate with the pattern formed thereon is fired in a firing furnace thereby burning out the organic component and sintering the glass powder, and thus an insulating layer is formed. The firing atmosphere, temperature and time can be appropriately selected according to the photosensitive composition and the kind of the substrate, and firing is carried out in an atmosphere such as air, nitrogen, or hydrogen. Firing is preferably carried out while maintaining at a temperature of 400 to 600°C for 10 to 60 minutes. As a firing furnace, a batch type firing furnace or a belt type continuous firing furnace can be used. During the above steps, heating at 50 to 300°C may be carried out for the purpose of drying and preliminary reaction.

An insulating layer for a field emission display, which has a pattern including circular holes having a thickness of 5 to 100 µm and a diameter of 3 to 100 µm or rectangular holes having a side of 3 to 100 µm, formed on a substrate is obtained by the above steps. For activation of a field emission display at a low voltage, it is necessary to reduce the distance between the gate electrode portion and the electron emission element. The thickness of the insulating layer is preferably 30 µm or less for the above purpose. For achievement of high resolution and equalization of luminance, the size of the holes formed on the insulating layer is preferably 30 µm or less.

A gate electrode is formed by the following method. After obtaining the insulating layer on which holes of a desired pattern is formed, a chromium film is uniformly formed thereon by a sputtering method or a vacuum deposition method. Next, a positive resist is applied on the entire surface of the chromium film using a known coating method such as a spin coating method or a screen printing method, and then prebaked on a hot plate. Next, a photomask with a desired pattern is placed on the resist layer, followed by irradiation with ultraviolet rays, and further exposure and development steps to form an etching mask of the positive resist remaining on the chromium film. Next, etching is carried out using an acidic etching liquid (diammonium cerium nitrate: 9 wt% + perchloric acid: 6 wt%) for several minutes to remove the portion, which is not coated with the etching mask, of the chromium film from the glass substrate. Next, the etching mask is removed using a remover, followed by washing with water so the masked chromium layer remains, and thus a gate electrode is formed. In this case, when the insulating layer has no resistance to the etching liquid, the insulating layer is dissolved in the etching step, and therefore it is necessary that the insulating layer is not easily dissolved in the etching liquid.

The electron emission element is formed by the following method. The formation method varies depending on an electron emission source. When the electron emission source is a spint type metal chip (or microchip) made mainly of molybdenum, a vacuum deposition method is preferred. When an electron emission source uses a carbon nano-tube (CNT), an electron emission element is formed by a method in which a CNT paste having photosensitivity is applied to the inside of holes of the insulating layer using a screen printing method and a substrate is irradiated with light from the rear face thereof, thereby selectively exposing only the hole inside portion of the CNT paste and removing the unexposed area, and thus only CNT inside the holes remains.

When the above substrate with the insulating layer, the gate electrode and the electron emission element formed thereon is used as a back plate and the back plate and a separately made front plate are sealed with each other, and then wirings are mounted, a field emission display having high luminance and high contrast can be obtained.

### EXAMPLES

The present invention will be specifically described by way of examples. However, the present invention is not limited thereto.

### <Measuring Procedure>

A weight average molecular weight of a binder polymer was measured by size exclusion chromatography using tetrahydrofuran as a mobile phase. Using Shodex KF-803 as a column, the weight average molecular weight was calculated in terms of a polystyrene equivalent.

An acid value of a binder polymer was determined by dissolving 1 g of the binder polymer in 100 mL of ethanol, followed by titration with an aqueous 0.1 N potassium hydroxide solution.

5 minutes after the measurement, the viscosity of a binder polymer was measured by a rotary viscometer (RVDVII+, manufactured by Brookfield Co.) at a temperature of 25±0.1°C and a revolution number of 10 rpm.

The thermal decomposition temperature of a binder polymer was determined by the following procedure. That is, about 20 mg of a sample was set to a TG measuring device (TGA-50, manufactured by Shimadzu Corporation) and the temperature was raised to 700°C at a temperature raising rate of 10°C/min under an air atmosphere at a flow rate of 20 ml/min. A chart with a plotted relation between the temperature (ordinate) and the change in weight (abscissas) was printed and a tangent line of the portion before decomposition and the portion during decomposition was drawn and the temperature of the intersection point was taken as the thermal decomposition temperature.

The glass transition point (Tg) of a binder polymer was determined by the following procedure. That is, the temperature was raised at a temperature raising rate of 20°C/min under a nitrogen gas flow at a flow rate of 20 ml/min (sample weight: 10 mg) using a measuring device Model DSC-50 manufactured by Shimadzu Corporation and the temperature, at which a shift of the base line is initiated, was taken as the Tg.

The thermosoftening temperature of a glass powder was determined by the following procedure. That is, the glass powder was placed in a platinum cell and differential thermal analysis was carried out from a normal temperature to 700°C at a temperature raising rate of 20°C/min using a differential thermal analyzer (TG8120, manufactured by Rigaku Corporation), and then the temperature, at which endotherm is completed via a minimum point of the endothermic portion which appears first, was taken as a softening point (Ts).

The average particle diameter of a glass powder was measured using a laser diffraction scattering measuring device (Microtrack particle size distribution meter HRA, manufactured by NIKKISO CO., LTD.). The specific gravity was measured using an Archimedes's method after forming glass into a sample measuring about 5 x 5 x 5 mm.

The refractive index of a glass powder was determined by the following procedure. That is, a glass film was formed on a quartz glass and measurement was carried out by an ellipsometry method using an ellipsometer with respect to light having a wavelength of 436 nm at 25°C.

The tack value of a photosensitive composition film was measured by the following procedure. A photosensitive composition was uniformly applied on a glass substrate entirely or partially, using screening printing and then dried in a hot air oven to form a film of the photosensitive composition. Drying in the hot air oven was carried out at 85°C for 20 minutes. The size of the substrate to be evaluated is a size which can be employed in an inclination type ball tack device described in JIS Z 0237 (2000). In the evaluation, 30° was employed as the inclination angle. The size of a ball of a material defined in JIS G 4805 (1999) was the size of, in total, thirty-one kinds from 1/16 to 1 (excluding five kinds of 5/64, 7/64, 9/64, 15/64 and 17/64) of the "nominal diameter of ball" defined in JIS B 1501 (1988) and the numerical value which is 32 times larger than the "nominal diameter of ball" was referred to as the ball number, which was taken as an indicator of tack properties. A glass substrate (thickness: 1.3 mm, 12.5 cm square) with the coated photosensitive composition facing upward was mounted at a predetermined position on a tilt board of an inclination type ball tack device and each ball having a different size was set to a gate. The gate was slowly opened thereby rolling the ball, and the ball completely stopped in the measuring portion (the ball does not move for 5 or more seconds) was monitored. The ball number of the largest ball among the balls stopped completely in the measuring portion was taken as the tack value of the photosensitive composition. Even in case of the smallest ball, the case where the ball does not stop was 0. A glass plate having the same thickness as the glass coated with the photosensitive composition was placed on a runaway so as not to form a step, and a PET film having a thickness of 20 µm was applied thereon. The measurement was carried out in a blackout curtain so as not to expose the composition to light.

### <Binder Polymer I>

It is a polymer having a weight average molecular weight of 17,000, an acid value of 100 mgKOH/g, a double bond density of 1.5 mmol/g and a viscosity of 8.2 Pa·s obtained by an addition reaction of a carboxyl group of a copolymer comprising 30 parts by weight of methyl acrylate, 40 parts by weight of ethyl acrylate and 30 parts by weight of methacrylic acid with 0.4 equivalents of glycidyl methacrylate (GMA). The resultant polymer had a thermal decomposition temperature of 390°C and a Tg of 25°C.

### <Binder Polymer II>

It is a polymer having a weight average molecular weight of 64,000, an acid value of 84 mgKOH/g, a double bond density of 0.5 mmol/g and a viscosity of 18 Pa·s obtained by an addition reaction of a carboxyl group of a copolymer comprising 45 parts by weight of isobutyl methacrylate, 25 parts by weight of 2-ethylhexyl acrylate, 13 parts by weight of methyl acrylate and 17 parts by weight of methacrylic acid with glycidyl methacrylate (GMA). As a result of the measurement of TG, the thermal decomposition temperature was 310°C and the Tg was 15°C.

### <Binder Polymer III>

It is a polymer having a weight average molecular weight 18,000, an acid value of 111 mgKOH/g, a double bond density of 1.4 mmol/g and a viscosity of 13.4 Pa·s obtained by an addition reaction of a carboxyl group of a copolymer comprising 40 parts by weight of methyl methacrylate, 30 parts by weight of ethyl acrylate and 30 parts by weight of methacrylic acid with 0.4 equivalents of glycidyl methacrylate (GMA). The resultant polymer had a thermal decomposition temperature of 422°C and a Tg of 38°C.

### <Binder Polymer IV>

It is a polymer having a weight average molecular weight of 16,000, an acid value of 105 mgKOH/g, a double bond density of 2.5 mmol/g and a viscosity of 11.2 Pa·s obtained by an addition reaction of a carboxyl group of a copolymer comprising 40 parts by weight of methyl methacrylate, 20 parts by weight of ethyl acrylate and 40 parts by weight of methacrylic acid with 0.4 equivalents of glycidyl methacrylate (GMA). The resultant polymer had a thermal decomposition temperature of 430°C and a Tg of 74°C.

### <Binder Polymer V>

It is a polymer having a weight average molecular weight of 31,000, an acid value of 58 mgKOH/g, a double bond density of 1.4 mmol/g and a viscosity of 7.7 Pa·s obtained by an addition reaction of a carboxyl group of a copolymer comprising 50 parts by weight of methyl methacrylate, 30 parts by weight of styrene and 20 parts by weight of methacrylic acid with 0.4 equivalents of glycidyl methacrylate (GMA). The resultant polymer had a thermal decomposition temperature of 421°C and a Tg of 94°C.

### <Binder Polymer VI>

It is a polymer having a weight average molecular weight of 22,000, an acid value of 52 mgKOH/g, a double bond density of 0.34 mmol/g and a viscosity of 13.3 Pa·s obtained by an addition reaction of a carboxyl group of a copolymer comprising 50 parts by weight of methyl methacrylate, 30 parts by weight of styrene and 20 parts by weight of methacrylic acid with 0.4 equivalents of glycidyl methacrylate (GMA). The resultant polymer had a thermal decomposition temperature of 402°C and a Tg of 106°C.

### <Binder Polymer VII>

It is a polymer having a weight average molecular weight of 34,000, an acid value of 102 mgKOH/g, a double bond density of 2.7 mmol/g and a viscosity of 8.3 Pa·s obtained by an addition reaction of a carboxyl group of a copolymer comprising 30 parts by weight of methyl methacrylate, 30 parts by weight of styrene and 40 parts by weight of methacrylic acid with 0.4 equivalents of glycidyl methacrylate (GMA). The resultant polymer had a thermal decomposition temperature of 433°C and Tg of 118°C.

### <Glass Powder I>

As a glass powder, a glass powder with the composition comprising Bi₂O₃ (74% by weight), SiO₂ (7.2% by weight), B₂O₃ (10% by weight), ZnO (2.3% by weight), ZrO₂ (2.2% by weight) and Al₂O₃ (2.5% by weight) was used. This glass powder had a thermosoftening temperature of 509°C, an average particle diameter of 0.5 µm, a specific gravity of 5.86 g/cm³ and a refractive index (n_{g}) of 2.15.

### <Glass Powder II>

As a glass powder, a glass powder with the composition comprising Bi₂O₃ (77% by weight), SiO₂ (6.7% by weight), B₂O₃ (10% by weight), ZrO₂ (0.58% by weight), ZnO (2.3% by weight) and Al₂O₃ (2.5% by weight) was used. This glass powder had a thermosoftening temperature of 493°C, an average particle diameter of 0.5 µm, a specific gravity of 6.0 g/cm³ and a refractive index (ng) of 2.2.

### <Glass Powder III>

As a glass powder, a glass powder with the composition comprising Bi₂O₃ (77.2% by weight), SiO₂ (6.9% by weight), B₂O₃ (10.2% by weight), ZrO₂ (0% by weight), ZnO (2.5% by weight) and Al₂O₃ (2.7% by weight) was used. This glass powder had a thermosoftening temperature of 493°C, an average particle diameter of 0.5 µm, a specific gravity of 6.1 g/cm³ and a refractive index (ng) of 2.21.

### <Glass Powder IV>

As a glass powder, a glass powder with the composition comprising Bi₂O₃ (67% by weight), SiO₂ (7.6% by weight), B₂O₃ (13.7% by weight), ZrO₂ (0% by weight), ZnO (8.0% by weight) and Al₂O₃ (3.2% by weight) was used. This glass powder had a thermosoftening temperature of 534°C, an average particle diameter of 1.4 µm, a specific gravity of 5.4 g/cm³ and a refractive index (ng) of 1.98.

### <Glass Powder V>

As a glass powder, a glass powder with the composition comprising Bi₂O₃ (67% by weight), SiO₂ (9.7% by weight), B₂O₃ (11.5% by weight), ZrO₂ (3.3% by weight), ZnO (3.8% by weight) and Al₂O₃ (4% by weight) was used. This glass powder had a thermosoftening temperature of 529°C, an average particle diameter of 0.5 µm, a specific gravity of 5.33 g/cm³ and a refractive index (ng) of 1.95.

### <Glass Powder VI>

As a glass powder, a glass powder with the composition comprising Bi₂O₃ (70% by weight), SiO₂ (16% by weight), B₂O₃ (9.2% by weight), ZrO₂ (0% by weight), ZnO (2.3% by weight) and Al₂O₃ (2.5% by weight) was used. This glass powder had a thermosoftening temperature of 590°C, an average particle diameter of 1.6 µm, a specific gravity of 5.0 g/cm³ and a refractive index (ng) of 1.95.

### <Glass Powder VII>

As an inorganic powder, a glass powder with the composition comprising PbO (70% by weight), SiO₂ (13% by weight), Al₂O₃ (3% by weight), B₂O₃ (10% by weight) and ZnO (4% by weight) was used. This glass powder had a thermosoftening temperature of 590°C, an average particle diameter of 1.2 µm and a refractive index (n_{g}) of 2.1.

### <Glass Powder VIII>

A glass powder with the composition comprising Bi₂O₃ (82% by weight), SiO₂ (4.9% by weight), B₂O₃ (8.1% by weight), ZnO (1.5% by weight), ZrO₂ (0.15% by weight) and Al₂O₃ (2.2% by weight) was used. This glass powder had a thermosoftening temperature of 462°C, an average particle diameter of 0.5 µm, a specific gravity of 6 g/cm³ and a refractive index (ng) of 2.31.

### <Filler I>

### Ceramics: Alumina particles having an average particle diameter of 37 nm (manufactured by C.I.KASEI CO., LTD. under the trade name of NanoTek)

The average particle diameter was determined by the following procedure. That is, after the specific surface area was measured by a BET method using a nitrogen gas, a particle diameter was determined from the specific surface area assuming that particles are in the form of a sphere, and then the number average particle diameter was determined.

### <Filler II>

### Silica: Silica particles having an average particle diameter of 12 nm (manufactured by Japan Aerogyl Co., Ltd. under the trade name of Aerogyl 200)

The average particle diameter was determined by the following procedure. That is, after the specific surface area was measured by a BET method using a nitrogen gas, the particle diameter was determined from the specific surface area assuming that particles are in the form of a sphere, and then the number average particle diameter was determined.

### <Compound (A)I>

In a cumarin-based derivative (manufactured by Nippon Kayaku Co., Ltd. under the trade name of Kayalight B) 3-methoxy-3-methyl-1-butanol solution, the ultraviolet absorption maximum wavelength was 370 nm and the fluorescence maximum emission wavelength was 441 nm.

### <Compound (A) II>

In an oxazole-based derivative (manufactured by Nippon Kayaku Co., Ltd. under the trade name of Kayalight O) 3-methoxy-3-methyl-1-butanol solution, the ultraviolet absorption maximum wavelength was 374 nm and the fluorescence maximum emission wavelength was 436 nm. In Table 1, a compound contained in a photosensitive organic component, which absorbs an exposure wavelength to emit light rays having a longer wavelength than that of the exposure wavelength, the emitted light curing or solubilizing the photosensitive organic component, is referred to as a compound (A).

### Example 1

7 parts by weight of an acryl monomer (manufactured by Nippon Kayaku Co., Ltd. KAYARAD® TPA-330) which is an ethylenically unsaturated group-containing compound as a photosensitive organic component; 7 parts by weight of the above binder polymer I; 10 parts by weight of a solvent (3-methyl-3-methoxybutanol); 2 parts by weight of a photopolymerization initiator (2,4-dimethylthioxanthone manufactured by Nippon Kayaku Co., Ltd. and Irgacure® 369 manufactured by Ciba Specialty Chemicals Inc. used in a weight ratio of 1:2); 3 parts by weight of a compound (A)I; 0.2 parts by weight of an ultraviolet ray absorber (azo-based organic dye 4-aminoazobenzene, manufactured by Wako Pure Chemical Industries, Ltd.); 0.3 parts by weight of a dispersing agent (manufactured by SAN NOPCO LIMITED under the trade name of NOPCOSPERSE 092); 0.5 parts by weight of a polymerization inhibitor (p-methoxyphenol) and 80 parts by weight of the above glass powder I as an inorganic component were mixed. The mixture was passed through three rollers five times to prepare a photosensitive composition. The resultant photosensitive composition was further filtered through a 400 mesh filter.

On a glass substrate, the above photosensitive composition was uniformly applied by screening printing and then dried by maintaining at 80°C for 15 minutes to form a 20 µm thick layer of the photosensitive composition. In such a manner, 10 samples were made and tack properties of the layer of the photosensitive composition were evaluated. As a result, all 10 samples showed a tack value of 6 or 8.

Using a negative chromium mask having a pattern of 20 µm via pattern/60 µm pitch and 30 µm via pattern/90 µm pitch, the layer was exposed to ultraviolet rays from a top surface by an ultrahigh-pressure mercury lamp at an output of 0.5 kw. The dose was 1 J/cm².

Then, development was carried out while showering with an aqueous 0.1 wt% solution of sodium carbonate maintained at 25°C for 30 seconds. The unphotocured area was removed by washing with water using shower spraying to form via patterns, each having a pore diameter of about 20 µm or 30 µm, on a glass substrate.

The refractive index (ng) of a photosensitive organic component was determined by the following procedure. That is, only photosensitive organic components were mixed, and then the mixture was applied on a substrate and dried. Using an ellipsometer, the refractive index was measured by an ellipsometry method with respect to light having a wavelength of 436 nm at 25°C. As a result, it was 1.52.

The substrate with a pattern formed thereon was observed by an optical microscope and the proportion of formation of corresponding via patterns among 100 via patterns of the mask was evaluated as the via processing rate (%). As a result, 100 via patterns having a pore diameter of about 20 µm or 30 µm were respectively formed and the via processing rate was 100%. The surface of the substrate with a pattern formed thereon was observed. As a result, cracking of the pattern was not observed. The substrate with a pattern formed thereon was fired by raising the temperature to about the softening point of a glass powder at a temperature rising rate of 4°C/min and maintaining for 20 minutes.

Then, a 100 nm thick chromium film was formed on the fired substrate with a pattern formed thereon by a sputtering method. A positive photoresist (manufactured by AZ Electronic Materials under the trade name of AZ1500) was applied on the resultant pattern substrate with a chromium film by a spin coater method and then baked at 100°C for one minute. The resultant photoresist film had a thickness of 1.5 µm. Using a negative chromium mask having a pattern of 25 µm via pattern/60 µm pitch and 37.5 µm via pattern/90 µm pitch, the film was exposed to ultraviolet rays from a top surface by an ultrahigh-pressure mercury lamp at an output of 0.5 kw. The dose was 100 mJ/cm ².

Then, development was carried out by dipping in a resist developing solution (prepared by diluting the trade name AZ400K manufactured by AZ Electronic Materials by 5 times) maintained at 25°C for 60 seconds, followed by shaking. Then, a resist pattern was obtained by washing with pure water for 30 seconds and post-baking at 120°C for 2 minutes.

Subsequently, a chromium etching liquid with the composition comprising 9% by weight of diammonium cerium nitrate, 6% by weight of perchloric acid and 85% by weight of pure water was maintained at 25°C and the substrate with a pattern formed thereon was dipped in the chromium etching liquid for 180 seconds, thereby etching a chromium film, followed by washing with pure water. Furthermore, a resist was removed by washing with acetone.

The surface of the resultant etched surface of the substrate with a pattern formed thereon was observed using a SEM (scanning electron microscope) and the etching residue was observed. Assuming that a lump having a size of 0.3 µm or more in an area of 3 µm square at 15,000-times magnification is regarded as the residue, the number was visually counted. This operation was repeated 10 times while changing the observation location. The average thereof was 1 and a small amount of the residue was observed.

The above photosensitive composition was prepared and then allowed to stand at room temperature, or allowed to stand in a thermostatic chamber at 22°C for one week. Then, a pattern was formed in the same manner as described above and the processing rate was evaluated. As a result, the via processing rate was entirely 100% and the composition was excellent in storage stability.

### Examples 2 to 10 and 13 to 21, Comparative Examples 1 to 4

In the same manner as in Example 1, except that the formulations described in Tables 1 and 2 were employed, photosensitive compositions were prepared, and then cracking after development, etching liquid resistance and tack value were evaluated.

### Example 11

In the same manner as in Example 1, except that the ultraviolet ray absorber in Example 1 was replaced by 4,4'-dimethylaminoazobenzene (azo-based organic dye, manufactured by Wako Pure Chemical Industries, Ltd.) and the amounts of the acryl monomer, the binder polymer and the glass powder were replaced by the amounts shown in Table 1, a photosensitive composition was prepared and pattern processability was evaluated. Even in a state where the amount of the glass powder is 90 parts by weight and is more than that of the photosensitive organic component, both via patterns having a pore diameter of about 20 µm and 30 µm showed a high via processing rate. The results are shown in Table 1.

### Example 12

In the same manner as in Example 1, except that the compound (A) in Example 1 was not added and the amounts of the acryl monomer, the binder polymer and the glass powder were replaced by the amounts shown in Table 1, a photosensitive composition was prepared and pattern processability was evaluated. The results are shown in Table 1.

**Table 1**

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Photosensitive organic component | Photosensitive organic component: Amount | Monomer (KAYARAD TPA-330): 7 Parts by weight | | | | | | | | | |
| | | Binder polymer I: 7 Parts by weight | | | Binder polymer II: 7 Parts by weight | Binder polymer I: 7 Parts by weight | | | | | |
| Inorganic component | Glass powder | II | II | III | I | I | I | I | I | I | I |
| | Amount (Parts by weight) | 80 | 80 | 80 | 80 | 80 | 70 | 80 | 80 | 80 | 80 |
| | Filler | - | - | - | - | - | I | - | - | - | - |
| | Amount (Parts by weight) | - | - | - | - | - | 10 | - | - | - | - |
| Compound (A) | Kind | I | | | | II | I | I | I | I | I |
| | Amount (Parts by weight) | 3 | 3 | 3 | 3 | 3 | 3 | 3.4 | 4.2 | 0.4 | 1 |
| | Amount (% by weight) in photosensitive organic component | 15 | 15 | 15 | 15 | 15 | 15 | 16.7 | 19.8 | 2.3 | 5.6 |
| Entire composition (excluding solvent: entire solids ) | Amount (Parts by weight) | 100 | 100 | 100 | 100 | 100 | 100 | 100.4 | 101.2 | 97.4 | 98 |
| Refractive index of photosensitive organic component (ng) | | 1.52 | 1.52 | 1.52 | 1.52 | 1.54 | 1.52 | 1.53 | 1.55 | 1.48 | 1.49 |
| Tack value | | 6-8 | 6-8 | 6-8 | 9 | 6-8 | 4-5 | 6-8 | 6-8 | 5-6 | 6-7 |
| Pattern processability | 30 µm via processing rate (%) | 100 | 100 | 100 | 100 | 100 | 100 | 95 | 90 | 100 | 100 |
| | 20 µm via processing rate (%) | 100 | 100 | 100 | 100 | 100 | 100 | 100 | 100 | 80 | 100 |
| Pattern processability (After one week) | 30 µm via processing rate (%) | 100 | 100 | 100 | 95 | 100 | 95 | 95 | 90 | 100 | 100 |
| | 20 µm via processing rate (%) | 100 | 100 | 100 | 95 | 100 | 95 | 100 | 100 | 80 | 100 |
| Cracking after development | | Not occurred | Not occurred | Not occurred | Not occurred | Not occurred | Not occurred | Not occurred | Not occurred | Not occurred | Not occurred |
| Residue after etching | | 1 | 0 | 0 | 1 | 1 | 1 | 1 | 1 | 1 | 1 |

**Table 2**

| | | Example 11 | Example 12 | Example 13 | Example 14 |
|---|---|---|---|---|---|
| Photosensitive organic component | Photosensitive organic component: Amount | Monomer (KAYARAD TPA-330): 3 Parts by weight | Monomer (KAYARAD TPA-330):12 parts by weight | Monomer (KAYARAD TPA-330):13 Parts by weight | Monomer (KAYARAD TPA-330) :10.5 parts by weight |
| | | Binder polymer I: 2.5 parts by weight | Binder polymer I: 12 parts by weight | Binder polymer I: 1 3 Parts by weight | Binder polymer I: 10.5 parts by weight |
| Inorganic component | Glass powder | III | I | I | I |
| | Amount (Parts by weight) | 90 | 70 | 68 | 70 |
| | Filler | - | - | - | - |
| | Amount (Parts by weight) | - | - | - | - |
| Compound (A) | Kind | I | - | I | I |
| | Amount (Parts by weight) | 1.5 | - | 3 | 3 |
| | Amount (% by weight) in photosensitive organic component | 15 | - | 9.4 | 11.1 |
| Entire composition (excluding solvent: entire solids ) | Amount (Parts by weight) | 100 | 97 | 100 | 97 |
| Refractive index of photosensitive organic component (ng) | | 1.52 | 1.47 | 1.5 | 1.47 |
| Tack value | | 0, 2 | 9 | 9 | 9 |
| Pattern processability | 30 µm via processing rate (%) | 100 | 70 | 80 | 90 |
| | 20 µm via processing rate (%) | 90 | 50 | 75 | 80 |
| Pattern processability (After one week) | 30 µm via processing rate (%) | 100 | 70 | 80 | 90 |
| | 20 µm via processing rate (%) | 90 | 50 | 75 | 80 |
| Cracking after development | | Not occurred | Not occurred | Not occurred | Not occurred |
| Residue after etching | | 1 | 1 | 1 | 1 |

**Table 3**

| | | Example 15 | Example 16 | Example 17 | Example 18 | Example 19 | Example 20 | Example 21 |
|---|---|---|---|---|---|---|---|---|
| Photosensitive organic component | Photosensitive organic component: Amount | Monomer (KAYARAD TPA-330): 7 Parts by weight | | | | | | |
| | | Binder polymer III: 7 Parts by weight | Binder polymer IV: 7 Parts by weight | Binder polymer V: 7 Parts by weight | Binder polymer VI: 7 Parts by weight | Binder polymer VII: 7 Parts by weight | Binder polymer IV: 7 Parts by weight | Binder polymer IV: 7 Parts by weight |
| Inorganic component | Glass powder | III | III | III | III | III | VIII | VIII |
| | Amount (Parts by weight) | 80 | 80 | 80 | 80 | 80 | 80 | 78 |
| | Filler | - | - | - | - | - | - | II |
| | Amount (Parts by weight) by | - | - | - | - | - | - | 2 |
| Compound (A) Compound (A) | Kind | I | I | I | I | I | I | I |
| | Amount (Parts by weight) | 3 | 3 | 3 | 3 | 3 | 3 | 3 |
| | Amount (% by weight) in Photosensitive organic component | 15 | 15 | 15 | 15 | 15 | 15 | 15 |
| Entire composition (excluding solvent: entire solids ) | Amount (Parts by weight) | 100 | 100 | 100 | 100 | 100 | 100 | 100 |
| Refractive index of photosensitive organic component (ng) | | 1.52 | 1.52 | 1.52 | 1.52 | 1.52 | 1.52 | 1.52 |
| Tack value | | 2-4 | 0 | 0 | 0 | 0 | 0 | 0 |
| Pattern processability | 30 µm via processing rate (%) | 100 | 100 | 100 | 100 | 100 | 100 | 100 |
| | 20 µm via rate processing (%) rate (%) | 100 | 100 | 100 | 100 | 100 | 100 | 100 |
| Pattern processability (After one week) | 30 µm via processing rate (%) | 100 | 100 | 100 | 100 | 100 | 100 | 100 |
| | 20µm via processing rate (%) | 100 | 100 | 100 | 100 | 100 | 100 | 100 |
| Cracking after development | | Not occurred | Not occurred | Not occurred | Occurred | Occurred | Not occurred | Not occurred |
| Residue after etching | | 1 | 1 | 1 | 1 | 1 | 1 | 1 |

**Table 4**

| | | Comparative Example 1 | Comparative Example 2 | Comparative Example 3 | Comparative Example 4 |
|---|---|---|---|---|---|
| Photosensitive organic component | Photosensitive organic component: Amount | Monomer (KAYARAD TPA-330): 8.5 parts by weight Binder polymer I: 8.5 parts by weight | | | |
| Inorganic component | Glass powder | IV | V | VI | VII |
| | Amount (Parts by weight) | 80 | | | |
| | Filler | - | | | |
| | Amount (Parts by weight) | - | | | |
| Compound (A) | Kind | - | | | |
| | Amount (Parts by weight) | - | | | |
| | Amount (% by weight) in photosensitive organic component | - | | | |
| Entire composition (excluding solvent: entire solids ) | Amount (Parts by weight) | 100 | | | |
| Refractive index of photosensitive organic component (ng) | | 1.47 | | | |
| Tack value | | 6-8 | 6-8 | 6-8 | 6-8 |
| Pattern processability | µm via processing rate (%) | 30 | 40 | 60 | 40 |
| | 20 µm via processing rate (%) | 5 | 10 | 50 | 10 |
| Pattern processability (After one week) | 30 µm via processing rate (%) | 25 | 35 | 55 | 0 |
| | 20 µm via processing rate (%) | 0 | 5 | 45 | 0 |
| Cracking after development | | Not occurred | Not occurred | Not occurred | Not occurred |
| Residue after etching | | Impossible to measure because of being dissolved | 9 | Impossible to measure because of being dissolved | Impossible to measure because of being dissolved |

### INDUSTRIAL APPLICABILITY

The photosensitive composition of the present invention has high storage stability and also can form a good fine pattern. The member obtained by using the photosensitive composition of the present invention is excellent in resistance to a strong acid. The photosensitive composition of the present invention can be fired at comparatively low temperature and therefore it can be preferably used as an insulating layer of a field emission display and an insulating layer of a fluorescent emission device.

## Claims

1. A photosensitive composition comprising 50 to 5% by weight of a photosensitive organic component and 50 to 95% by weight of a glass powder, wherein the glass powder contains 70 to 85% by weight of Bi₂O₃, 3 to 15% by weight of SiO₂, 5 to 20% by weight of B₂O₃, 0 to 3% by weight of ZrO₂ and 1 to 10% by weight of ZnO, expressed in terms of oxide.

2. The photosensitive composition according to claim 1, wherein the photosensitive organic component contains a compound which absorbs light to emit light rays having a longer wavelength than that of the absorbed light and the content of the compound is from 0.1 to 30% by weight based on the photosensitive organic component.

3. The photosensitive composition according to claim 2, wherein the compound absorbs light having a wavelength used for exposure to emit light rays having a longer wavelength than that of the absorbed light, and the emitted light cures or solubilize the photosensitive organic component.

4. The photosensitive composition according to claim 1, wherein the glass powder has an average refractive index of 1.8 or more and 2.2 or less.

5. The photosensitive composition according to claim 1, wherein the glass powder has a thermosoftening temperature within a range from 350 to 600°C.

6. The photosensitive composition according to claim 1, wherein the glass powder has an average particle diameter within a range from 0.1 to 5 µm.

7. The photosensitive composition according to claim 2, wherein the compound, which absorbs light to emit light rays having a longer wavelength than that of the absorbed light, shows a maximum absorption within a range from 350 to 380 nm, and also a maximum emission wavelength of fluorescence as measured in a 3-methoxy-3-methyl-1-butanol solution is within a range from 400 to 450 nm.

8. The photosensitive composition according to claim 2, wherein the compound, which absorbs light to emit light rays having a longer wavelength than that of the absorbed light, is a cumarin derivative.

9. The photosensitive composition according to claim 2, wherein solubility of the compound, which absorbs light to emit light rays having a longer wavelength than that of the absorbed light, in a polar solvent is 2 g/100 g of a solvent or more.

10. The photosensitive composition according to claim 2, wherein the compound, which absorbs light to emit light rays having a longer wavelength than that of the absorbed light, has a molar extinction coefficient of 20,000 or more.

11. The photosensitive composition according to claim 1, wherein the film of the photosensitive composition formed on a substrate has a tack value of 0 to 4.

12. A method for producing a display member, which comprises a step of coating the photosensitive composition according to claim 1, an exposure step, a developing step, and a firing step in this order.

13. A display member comprising a substrate and an insulating layer made of glass formed on the substrate, wherein the glass has the composition comprising 70 to 85% by weight of Bi₂O₃, 3 to 15% by weight of SiO₂, 5 to 20% by weight of B₂O₃, 0 to 3% by weight of ZrO₂ and 1 to 10% by weight of ZnO, expressed in terms of oxide.
